# EUROPEAN PATENT APPLICATION

(11) **EP 4 411 815 A1**
(43) Date of publication of application: **07.08.2024**
(21) Application number: 22872478.7
(22) Date of filing: 14.06.2022
(51) Int. Cl.: H01L 23/50

(54) **SEMICONDUCTOR DEVICE AND METHOD FOR MANUFACTURING SAME**

(30) Priority: 27.09.2021 JP 2021156848
(71) Applicant: Towa Corporation, Kyoto-shi, Kyoto 601-8105 (JP)
(72) Inventor: TAKAMORI, Yudai, Kyoto-shi, Kyoto 601-8105 (JP); NAKAMURA, Yoshito, Kyoto-shi, Kyoto 601-8105 (JP); FUJIWARA, Naomi, Kyoto-shi, Kyoto 601-8105 (JP); HANASAKA, Syuho, Kyoto-shi, Kyoto 601-8105 (JP); MIYATA, Kazushi, Kyoto-shi, Kyoto 601-8105 (JP); ISHIBASHI, Kanji, Kyoto-shi, Kyoto 601-8105 (JP)
(74) Representative: Vossius & Partner Patentanwälte Rechtsanwälte mbB
(86) International application number: PCT/JP2022/023774
(87) International publication number: WO 2023/047720

(57) **Abstract**

A method for manufacturing a semiconductor device includes a resin sealing step for sealing a semiconductor chip (6) with a resin material (9) in a state where the semiconductor chip (6) is bonded on a lead frame (1) in which a depressed portion (5) is formed, a laser light irradiation step for irradiating the depressed portion (5) with laser light to remove the resin material (9) in the depressed portion (5) by the laser light so that a part (9c) of the resin material (9) remains in the depressed portion (5), and a cutting step for cutting a bottom face (4v) of the depressed portion (5) in the lead frame (1) together with the part (9c) of the resin material (9) in the depressed portion (5).

## Description

### TECHNICAL FIELD

The present application relates to a semiconductor device and a method for manufacturing the same.

### BACKGROUND ART

As disclosed in PTL 1 (Japanese Patent Laying-Open No. 2019-102757), a quad flat non-leaded package (QFN) substrate is divided to produce a QFN type semiconductor device. Through the division, a plurality of minute electrodes are exposed on an end face of the semiconductor device. PTL 1 discloses (in paragraph
) that when a burr occurs in these electrodes, interconnection among the electrodes (shorting) may arise, or at the time of arranging the semiconductor device on a mother substrate, the semiconductor device may fail to be successfully placed on the substrate.

In the semiconductor device disclosed in PTL 2 (Japanese Patent Laying-Open No. 2011-077278), a depressed portion (recess) is formed in a portion of a lead unit of a lead frame, which is on the opposite side of the chip mounting face. PTL 1 discloses (in paragraphs [0062], [0063], and the like) that the semiconductor device can be obtained by removing a resin material with which a depressed portion is filled, through application of laser light onto the depressed portion, thus causing a plating film that covers a part of the depressed portion on the lower face side (the opposite side of the chip mounting face) to be exposed toward the outside, and after that, dividing the package along the depressed portion using a blade.

### CITATION LIST

### PATENT LITERATURE

PTL 1: Japanese Patent Laying-Open No. 2019-102757
PTL 2: Japanese Patent Laying-Open No. 2011-077278

### SUMMARY OF INVENTION

### TECHNICAL PROBLEM

It is assumed that a depressed portion formed in a lead frame is irradiated with laser light and a resin material with which the depressed portion is filled is entirely removed. In this case, when package division is conducted along the depressed portion using a blade, a burr can easily occur on a bottom face of the depressed portion in the lead frame (an end face of a part that forms the depressed portion). The lead frame is made of copper in many cases and copper has the property of being relatively soft, compared among typical metal materials. In the lead frame made of copper, burrs can often vary in height. In a semiconductor device where a terminal side face is exposed, such as a QFN, if burrs having various heights occur on an end face of a terminal unit, individual variation in mounting height, flatness, and the like can be caused or the mounting strength can decrease, depending on the heights of the burrs.

The present application is aimed at disclosing a semiconductor device with a configuration that can inhibit occurrence of burrs on a bottom face of a depressed portion in a lead frame, and a method for manufacturing the semiconductor device.

### SOLUTION TO PROBLEM

A method for manufacturing a semiconductor device according to the present disclosure includes a resin sealing step for sealing a semiconductor chip with a resin material in a state where the semiconductor chip is bonded on a lead frame in which a depressed portion is formed, a laser light irradiation step for irradiating the depressed portion with laser light to remove the resin material in the depressed portion by the laser light so that a part of the resin material remains in the depressed portion, and a cutting step for cutting a bottom face of the depressed portion in the lead frame together with the part of the resin material in the depressed portion.

A semiconductor device according to the present disclosure includes a lead frame in which a depressed portion is formed, and a semiconductor chip bonded on the lead frame and resin-sealed with a resin material. This semiconductor device is produced by cutting a bottom face of the depressed portion in the lead frame. The bottom face of the depressed portion in the lead frame and the resin material in the depressed portion overlap each other in a height direction of the lead frame.

### ADVANTAGEOUS EFFECTS OF INVENTION

The above described features can bring a semiconductor device with a configuration that can inhibit occurrence of burrs on a bottom face of a depressed portion in a lead frame, and a method for manufacturing the semiconductor device.

### BRIEF DESCRIPTION OF DRAWINGS

Fig. 1 is a plan view illustrating a lead frame, which is prepared in a preparation step, and a plurality of semiconductor chips.
Fig. 2 is a cross sectional view taken along line II-II of the arrows in Fig. 1 and illustrates a state where the semiconductor chips are bonded on the lead frame (die pads) in which depressed portions are formed.
Fig. 3 is a cross sectional view illustrating a state where a resin sealing step has been performed.
Fig. 4 is a cross sectional view illustrating a state where a protection film has been removed before a laser light irradiation step is performed.
Fig. 5 is a cross sectional view illustrating a state where the laser light irradiation step is performed.
Fig. 6 is a cross sectional view illustrating a state after a plating step has been performed.
Fig. 7 is a cross sectional view illustrating a state where a cutting step is performed.
Fig. 8 is a perspective view illustrating a semiconductor device obtained by a manufacturing method according to an embodiment.
Fig. 9 is a perspective view illustrating, in an enlarged scale, an end face of the semiconductor device obtained by the manufacturing method according to the embodiment.
Fig. 10 is a cross sectional view illustrating a state where the semiconductor device obtained by the manufacturing method according to the embodiment is mounted.
Fig. 11 is a cross sectional view illustrating a state after a plating step has been performed in a method for manufacturing a semiconductor device according to a comparative example.
Fig. 12 is a cross sectional view illustrating a state where a cutting step is performed in the method for manufacturing a semiconductor device according to the comparative example.
Fig. 13 is a cross sectional view illustrating a state where a semiconductor device obtained by a method for manufacturing a semiconductor device according to another comparative example is mounted.
Fig. 14 is a cross sectional view illustrating a state where the laser light irradiation step is performed by a method for manufacturing a semiconductor device according to a variation of the embodiment.
Fig. 15 is a cross sectional view for explaining conditions for an example of experiment conducted with respect to the embodiment.
Fig. 16 is a table indicating the results of the example of experiment conducted with respect to the embodiment.

### DESCRIPTION OF EMBODIMENTS

Referring to the drawings, embodiments are described hereinafter. In the description below, identical reference numerals are given to identical components and equivalent components, and description of the components may not be repeated. A method for manufacturing a semiconductor device according to an embodiment includes a preparation step, a resin sealing step, a laser light irradiation step, a plating step, and a cutting step. These are described sequentially below.

### (Preparation Step)

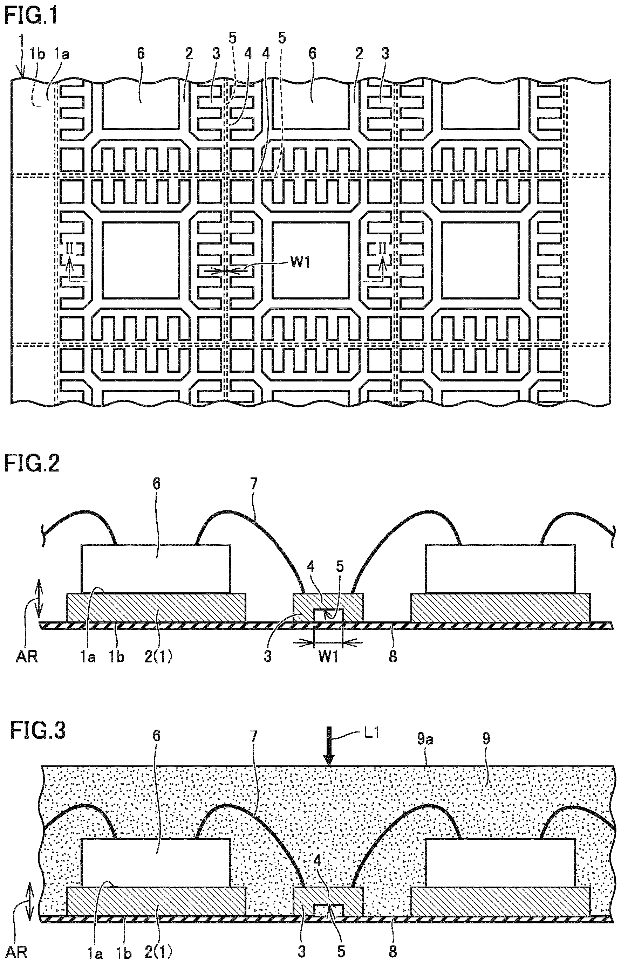

Fig. 1 is a plan view illustrating a lead frame 1 and a plurality of semiconductor chips 6, which are prepared in the preparation step. Lead frame 1 is made of metal such as copper and shaped like a flat plate, and includes a front-side face 1a and a back-side face 1b. Fig. 1 presents a plan view of lead frame 1 viewed from the side of front-side face 1a.

Lead frame 1 includes a plurality of die pads 2, which are arranged like a matrix, a plurality of leads 3, which are arranged around (four sides of) each die pad 2, and tie bars 4, which couple and surround leads 3 arranged around the four sides of respective die pad 2. A chip mounting face is provided on the side of front-side face 1a of lead frame 1 (die pad 2) while depressed portions 5, described later, are provided on the side of back-side face 1b of lead frame 1 (tie bar 4). Fig. 1 illustrates a state where semiconductor chips 6 are arranged on respective die pads 2.

Tie bars 4 are formed like a lattice over lead frame 1. Depressed portions 5, which extend along tie bars 4, are formed in advance in lead frame 1. Depressed portion 5 is formed so as to be depressed from back-side face 1b toward front-side face 1a in a height direction of lead frame 1 (in a direction AR of the arrows illustrated in Fig. 2). Depressed portion 5 extends like a groove on back-side face 1b of lead frame 1, and depressed portion 5 has a width dimension W1 (Figs. 1 and 2) in a direction orthogonal to the direction in which depressed portion 5 extends. Width dimension W1 is between 0.40 mm and 0.50 mm for example.

Depressed portion 5 does not pierce lead frame 1 from the side of back-side face 1b to the side of front-side face 1a but for example, has a height (synonymous with a depth here) that is half of the thickness of lead frame 1 and can be formed through etching (wet etching) on lead frame 1. Width dimension W1 and the height dimension of depressed portion 5 are set to optimal values by taking account of the securing of a strength sufficient to prevent imperfections including deformation in a later step, the possibility of performing a favorable appearance inspection in a later step, a favorable mounting strength of the semiconductor device as a finished product, and the like.

Fig. 2 is a cross sectional view taken along line II-II of the arrows in Fig. 1 and illustrates a state where semiconductor chips 6 are bonded on lead frame 1 (die pads 2) in which depressed portions 5 are formed. As illustrated in Fig. 2, a plurality of electrodes provided on respective semiconductor chips 6 are electrically connected to leads 3 (Fig. 1) via bonding wires 7. For convenience, bonding wires 7 are not illustrated in Fig. 1.

### (Resin Sealing Step)

Fig. 3 is a cross sectional view illustrating a state where the resin sealing step has been performed. In the resin sealing step, semiconductor chips 6 are sealed on lead frame 1 with a resin material 9 in a state where semiconductor chips 6 are bonded on lead frame 1. As illustrated in Figs. 2 and 3, desirably, a protection film 8 (a polyimide resin tape for example) is stuck on the side of depressed portions 5 in lead frame 1 prior to the resin sealing step and the resin sealing is performed with protection film 8 stuck.

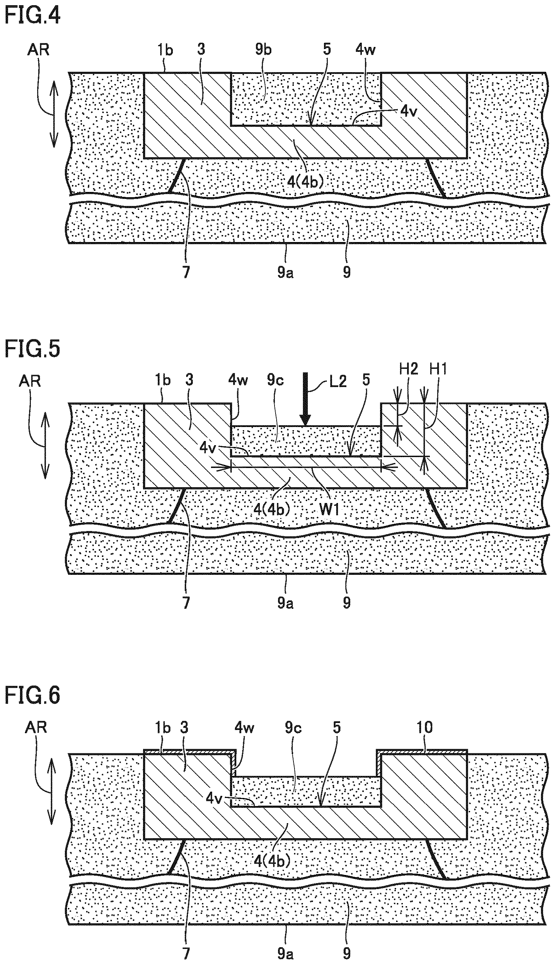

Depressed portions 5 are filled with resin material 9 (9b) (see Fig. 4) by performing the resin sealing step. Resin material 9 (9b) covers and conceals inner wall faces 4w (Fig. 4) and a bottom face 4v (Fig. 4) of a portion 4b that is included in lead frame 1 (tie bar 4) and defines depressed portion 5. Here, inner wall face 4w of tie bar 4 is for example, a plane extending from back-side face 1b of tie bar 4 in height direction AR or a plane extending in a direction orthogonal to back-side face 1b of tie bar 4. Bottom face 4v of tie bar 4 is for example, a plane extending in parallel to back-side face 1b of tie bar 4 or a plane extending in a direction orthogonal to height direction AR. Bottom face 4v and the pair of inner wall faces 4w positioned on both outer sides of bottom face 4v define depressed portion 5 as a space.

As illustrated in Fig. 4, protection film 8 is peeled off from back-side face 1b of lead frame 1 before a laser light irradiation step is performed, which is described later. The removal of protection film 8 causes back-side face 1b of lead frame 1 and resin material 9 (9b) provided in depressed portion 5 of lead frame 1 to be exposed.

### (Laser Light Irradiation Step)

As illustrated in Fig. 5, in the laser light irradiation step, resin material 9 in depressed portion 5 is irradiated with laser light L2. Laser light L2 could be provided by pulsed laser such as YAG laser or YVO4 laser emitted from a lasing device, or a green laser in which the wavelength of the laser light emitted therefrom is converted by a second harmonic generation (SHG) material. Also, an irradiation region of laser light L2 can be varied by scanning by a scanning optical system.

When the irradiation with laser light L2 is continued, resin material 9 (9b) is removed and inner wall faces 4w of tie bar 4 (portion 4b that forms depressed portion 5) are exposed accordingly. Resin material 9 is removed by an amount of predetermined height dimension H2 with respect to a height dimension H1 of inner wall face 4w that forms depressed portion 5. Here, instead of entirely removing resin material 9 (9b) in depressed portion 5, resin material 9 in depressed portion 5 is removed by laser light L2 so that a part 9c of resin material 9 (9b) remains in depressed portion 5. On the basis of the properties of resin material 9 and the size of resin material 9 (width dimension W1 of depressed portion 5, and the like), the wavelength, output, laser diameter, duration of the irradiation, and the like of laser light L2 are optimized so that a desired amount of resin material 9 remains.

### (Plating Step)

As illustrated in Fig. 6, lead frame 1 is plated after resin material 9 in depressed portion 5 is removed so that part 9c of resin material 9 remains in depressed portion 5, that is, after the laser light irradiation step. Consequently, a plating layer 10 is formed on back-side face 1b of die pad 2 (not illustrated) of lead frame 1, back-side face 1b of tie bar 4 of lead frame 1, and inner wall faces 4w.

As a material of plating layer 10, a material with a favorable solder wettability can be selected, depending on the solder material used for the mounting. For example, when a Sn (tin)-based solder is used, tin (Sn), a tin-copper (Sn-Cu) alloy, a tin-silver (Sn-Ag) alloy, tin-bismuth (Sn-Bi), or the like can be employed and plating layer 10 can also be made as a multilayer structure in which Ni is used for the base on the lead frame 1 side. In the plating step, the plating is desirably performed after carrying out predetermined cleaning on lead frame 1. As surface treatment for lead frame 1 as pretreatment in the plating step, operations for removal of an oxide film, surface activation, and the like may be performed in addition to the cleaning.

### (Cutting Step)

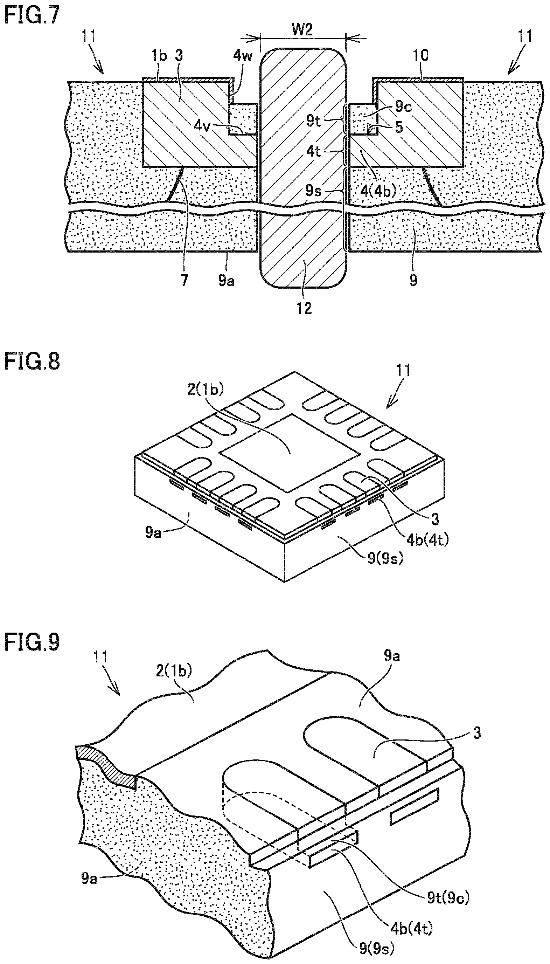

As illustrated in Fig. 7, after plating lead frame 1, bottom face 4v of depressed portion 5 (portion 4b that forms depressed portion 5) of lead frame 1 (tie bar 4) is cut together with part 9c of resin material 9 in depressed portion 5. In the cutting step, a blade 12 is used to cut part 9c of resin material 9, portion 4b of lead frame 1 (tie bar 4), and resin material 9 present from lead frame 1 to a front-side face 9a. A width dimension W2 of blade 12 is a value smaller than that of width dimension W1 of depressed portion 5 (Figs. 1, 2, and 5).

By performing the cutting step, a plurality of semiconductor devices 11 are obtained. On an end face formed through the cutting for semiconductor devices 11, resin end faces 9t and 9s and a metal end face 4t are exposed. Resin end face 9t is formed by cutting part 9c of resin material 9 and resin end face 9s is formed by cutting resin material 9 present from lead frame 1 to front-side face 9a. Metal end face 4t is formed by cutting bottom face 4v of lead frame 1 (tie bar 4) (portion 4b that forms depressed portion 5).

Fig. 8 is a perspective view illustrating semiconductor device 11 obtained by a manufacturing method according to the embodiment and Fig. 9 is a perspective view illustrating semiconductor device 11 in an enlarged scale. As illustrated in Figs. 8 and 9, semiconductor device 11 is a non-leaded product of a QFN type, where leads for electrical connection do not project outside the product in a plan view. Part 9c of resin material 9 still remains inside depressed portion 5 (see Fig. 7), that is, in a corner portion between inner wall face 4w and bottom face 4v.

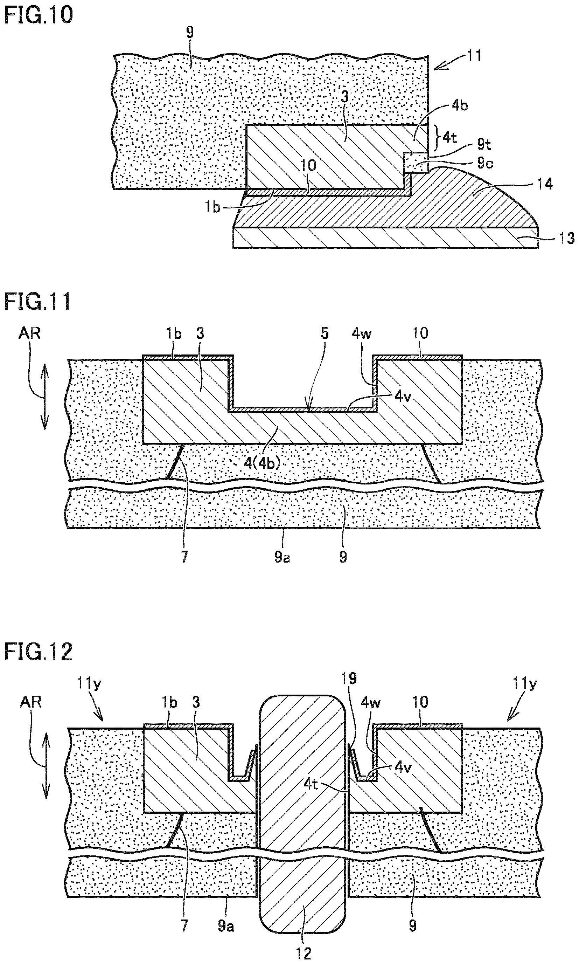

As illustrated in Fig. 10, in semiconductor device 11, a level difference is made in a side portion (an edge portion) of each lead 3, and plating layer 10 is not formed on metal end face 4t of lead 3 and the original metal is exposed. Semiconductor device 11 is mounted over a printed board with leads 3 facing downward, for example. On the printed board, lands 13 are formed in positions corresponding to leads 3, and leads 3 and lands 13 are electrically connected with solder 14 interposed therebetween.

In semiconductor device 11, a fillet of solder 14 is formed on the level difference made in the side portion (edge portion) of lead 3 and whether solder connection is suitably established can be determined easily by referring to how this fillet is shaped.

### (Effects and Advantages)

Effects and advantages that the aforementioned embodiment brings are described below by referring to a comparative example illustrated in Figs. 11 and 12. Fig. 11 is a cross sectional view illustrating a state after a plating step has been performed in a method for manufacturing a semiconductor device according to the comparative example.

As illustrated in Fig. 11, in the comparative example, a resin material 9 (not illustrated in Fig. 11) with which a depressed portion 5 is filled is entirely removed by irradiating depressed portion 5 provided in a lead frame 1 with laser light and after that, a plating layer 10 is formed on lead frame 1.

When a cutting step is performed in the state illustrated in Fig. 11, a portion 4b of lead frame 1 (a tie bar 4) (a bottom face 4v of depressed portion 5) and resin material 9 present from lead frame 1 to a front-side face 9a are cut. At this time, unlike the embodiment, resin (a part 9c of resin material 9) is not present on the side of a back-side face 1b of portion 4b of tie bar 4 (the upper side of portion 4b (bottom face 4v) of tie bar 4 in the sheet of Fig. 11).

As illustrated in Fig. 12, in performing the cutting by a blade 12, a possible resistance to occurrence of a burr 19 is not present at all on an end face of portion 4b of tie bar 4, which is formed through the cutting by blade 12. In the comparative example, burr 19 is caused more easily by the cutting step than in the embodiment and thus, as illustrated in Fig. 12, burr 19 is formed and extends in a height direction AR of lead frame 1 in a semiconductor device 11y produced by the manufacturing method according to the comparative example. As mentioned at the outset, if burrs 19 having various heights occur on a metal end face 4t, variation in mounting height, flatness, and the like can be caused or the mounting strength can decrease, depending on the heights of the burrs 19.

In contrast, in the above-described embodiment, when the cutting by blade 12 (see Fig. 7) is performed, part 9c of resin material 9 or resin end face 9t of resin material 9 is present on an end face of portion 4b of tie bar 4 (the portion that serves as metal end face 4t in Fig. 8), which is formed through the cutting by blade 12. Since the presence of part 9c of resin material 9 can be a resistance to the occurrence of burr 19, the occurrence of burr 19 can be inhibited more effectively than in the comparative example, and variation in mounting height and flatness or decrease in mounting strength can be further inhibited than in the comparative example.

As a favorable example (see Fig. 7), it is preferable that in the state where lead frame 1 is cut in the cutting step, bottom face 4v of depressed portion 5 in lead frame 1 (tie bar 4) and part 9b of resin material 9 in depressed portion 5 overlap each other in height direction AR of lead frame 1. Part 9c of resin material 9 is formed so as to be present as close as possible to metal end face 4t (remain in depressed portion 5), which enables part 9c of resin material 9 to serve as a resistance to the occurrence of burr 19 more effectively.

In a similar respect (see Fig. 7), it is also effective in terms of inhibition of the occurrence of burr 19 that in the state where lead frame 1 is cut in the cutting step, metal end face 4t of portion 4b forming depressed portion 5 in lead frame 1 (tie bar 4) and resin end face 9t formed in part 9c of resin material 9 have a relation of being flush with each other. Part 9c of resin material 9 has resin end face 9t present as close as possible to metal end face 4t (remains in depressed portion 5), which enables part 9c of resin material 9 to serve as a resistance to the occurrence of burr 19 more effectively.

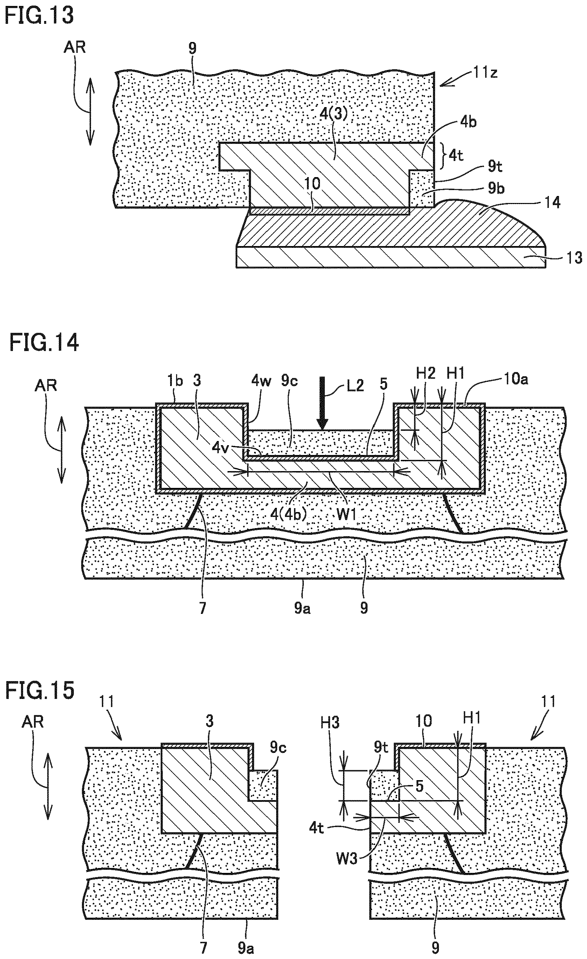

Fig. 13 is a cross sectional view illustrating a state where a semiconductor device obtained by a method for manufacturing a semiconductor device according to another comparative example is mounted. In the present comparative example, a laser light irradiation step is not performed and a resin material 9 with which the inside of a depressed portion 5 is filled is not removed at all. In a semiconductor device 11z thus produced, resin material 9 (9b) remains in depressed portion 5 in the filled state, and resin material 9 (9b) can serve as a resistance to the occurrence of a burr in a cutting step.

However, in semiconductor device 11z, almost no level difference is made in a side portion (edge portion) of a lead 3 and formation of a fillet of solder 14 is hampered, and it is difficult to determine whether solder connection is suitably established by referring to how the fillet is shaped. Also in this respect, according to the above-described embodiment (see Fig. 10), a fillet of solder 14 can be formed easily and suitably in a level difference made in a side portion (an edge portion) of lead 3 and whether solder connection is suitably established can be easily determined by referring to the state of the fillet.

### [Variations of Embodiment]

### (Variation 1)

In the above-described embodiment, as illustrated in Figs. 2 and 3, protection film 8 (a polyimide resin tape for example) is stuck on the side of depressed portions 5 in lead frame 1 prior to the resin sealing step and the resin sealing is performed with protection film 8 stuck. Such a configuration is not necessarily required. For example, the resin sealing step can be performed without sticking a tape such as protection film 8 by using a lead frame that has undergone premolding (preliminary resin sealing) prior to the resin sealing step.

### (Variation 2)

In the above-described embodiment, lead frame 1 is plated after the laser light irradiation step and plating layer 10 (Fig. 6) is formed on back-side face 1b of lead frame 1, and the like. Such a configuration is not necessarily required, either. That is, it is also effective to use lead frame 1 with a plating layer formed thereon in advance in a state before the bonding of semiconductor chip 6 to lead frame 1. In other words, lead frame 1 that has already been plated may be used in the resin sealing step. When lead frame 1 that has been plated in advance is used, Pd (Pd-PPF) is desirably employed, which is high in heat resistance temperature, as a plating material rather than Sn.

Fig. 14 is a cross sectional view illustrating a state where the laser light irradiation step is performed by the method for manufacturing a semiconductor device according to the variation of the embodiment. When lead frame 1 on which a plating layer 10a (Fig. 14) has been formed in advance is used, the plating for lead frame 1 after performing the laser light irradiation step as illustrated in Fig. 14 is not necessarily required. Even when plating layer 10a has been formed on lead frame 1 in advance, part 9c of resin material 9 remains in depressed portion 5 in the laser light irradiation step and accordingly, a breakage of plating layer 10a caused by the laser light irradiation can be inhibited.

As illustrated in Fig. 14, transition to the cutting step without interruption is enabled after the laser light irradiation step is performed so that part 9c of resin material 9 remains. It is enabled to shorten the time necessary for the manufacture by the person-hours taken to transfer a package to an equipment unit for the plating and perform the plating, and transfer the package to a cutting apparatus therefrom, or enabled to contiguously place other equipment units necessary for the manufacture than that for the plating. As a result, the productivity can be increased.

### [Example of Experiment]

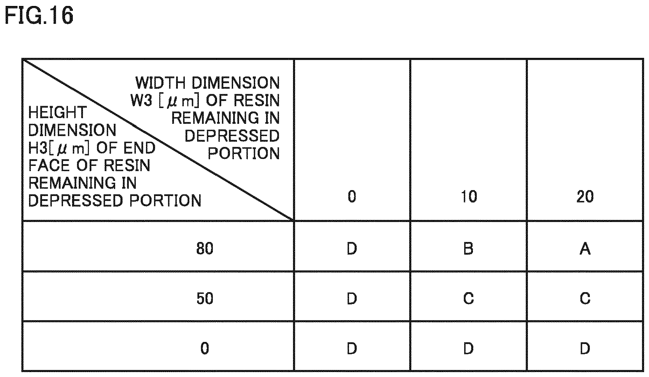

Fig. 15 is a cross sectional view for explaining conditions for an example of experiment that was conducted with respect to the embodiment. Fig. 16 is a table indicating the results of this example of experiment. As illustrated in Fig. 15, depressed portion 5 depressed in height direction AR is formed in lead frame 1 and depressed portion 5 (synonymous with inner wall face 4w here) has height dimension H1 in height direction AR.

In the state where lead frame 1 is cut in the cutting step, part 9c of resin material 9 that remains in depressed portion 5 has resin end face 9t exposed through the cutting. Resin end face 9t of part 9c of resin material 9 (the resin material remaining in depressed portion 5) has a height dimension H3 in height direction AR, and part 9c of resin material 9 (the resin material remaining in depressed portion 5) has a width dimension W3 in the width direction.

In the experiment, it was verified how the relations among height dimension H1 of depressed portion 5, height dimension H3 of resin end face 9t of the resin material remaining in depressed portion 5, and width dimension W3 of the resin material remaining in depressed portion 5 affect the occurrence of burrs, and the results indicated in Fig. 16 were obtained. Evaluation A was given to a case where the degree of the occurrence of burrs is the lowest while evaluations B, C, and D were given as the degree of the occurrence of burrs increases. Here, width dimension W1 (see Fig. 5) of depressed portion 5 was assumed to be 440 µm and height dimension H1 of depressed portion 5 was assumed to be 100 µm.

As illustrated in Fig. 16, when height dimension H3 of the resin material remaining in depressed portion 5 was set to be 80 µm and width dimension W3 of the resin material remaining in depressed portion 5 was set to be 0 µm, 10 µm, and 20 µm, evaluations D, B, and A were obtained, respectively. When width dimension W3 of the resin material remaining in depressed portion 5 was 0 µm, it is synonymous with that the resin material was entirely removed from the inside of depressed portion 5.

As illustrated in Fig. 16, when height dimension H3 of the resin material remaining in depressed portion 5 was set to be 50 µm and width dimension W3 of the resin material remaining in depressed portion 5 was set to be 0 µm, 10 µm, and 20 µm, evaluations D, C, and C were obtained, respectively.

As illustrated in Fig. 16, when height dimension H3 of the resin material remaining in depressed portion 5 was set to be 0 µm, that is, in the state where the resin in depressed portion 5 was entirely removed, evaluation D was obtained.

The experimental results indicated in Fig. 16 show that when width dimension W3 of the resin material remaining in depressed portion 5 is 10 µm, the occurrence of burrs can be inhibited more than in the case of 0 µm (that is, the case where no resin remains in depressed portion 5), and it can be further inhibited in the case of 20 µm. It is conceivable that when width dimension W3 of the resin material remaining in depressed portion 5 is small, a blade can come into contact with plating layer 10 on inner wall faces 4w during the dicing and plating expansion can be caused. From this viewpoint, it is preferable to ensure a certain largeness of width dimension W3 of the resin material remaining in depressed portion 5.

According to the experimental results indicated in Fig. 16, when height dimension H3 of resin end face 9t of the resin material remaining in depressed portion 5 is noted, that is, in the state where lead frame 1 is cut in the cutting step, part 9b of resin material 9 in depressed portion 5 has resin end face 9t formed through the cutting, and when height dimension H3 of resin end face 9t in height direction AR relative to height dimension H1 of depressed portion 5 (100 µm) in height direction AR is larger than or equal to 50 µm and smaller than or equal to 80 µm, an evaluation higher than or equal to C can be obtained. In terms of inhibition of the occurrence of burrs, height dimension H3 of resin end face 9t is preferably 50% or more and 80% or less of height dimension H1 of depressed portion 5.

Although embodiments are described above, the details of the above disclosure present examples in every respect and are not limiting. The technical scope of the present invention is defined by the claims and intended to include all changes within the purport and scope equivalent to the claims.

### REFERENCE SIGNS LIST

1 lead frame; 1a, 9a front-side face; 1b back-side face; 2 die pad; 3 lead; 4 tie bar; 4b portion; 4t metal end face; 4v bottom face; 4w inner wall face; 5 depressed portion; 6 semiconductor chip; 7 bonding wire; 8 protection film; 9 resin material; 9b, 9c part; 9s, 9t resin end face; 10, 10a plating layer; 11, 11y, 11z semiconductor device; 12 blade; 13 land; 14 solder; 19 burr; A, B, C, D evaluation; AR height direction; H1, H2, H3 height dimension; L2 laser light; W1, W2, W3 width dimension

## Claims

1. A method for manufacturing a semiconductor device, the method comprising:
a resin sealing step for sealing a semiconductor chip with a resin material in a state where the semiconductor chip is bonded on a lead frame in which a depressed portion is formed;
a laser light irradiation step for irradiating the depressed portion with laser light to remove the resin material in the depressed portion by the laser light so that a part of the resin material remains in the depressed portion; and
a cutting step for cutting a bottom face of the depressed portion in the lead frame together with the part of the resin material in the depressed portion.

2. The method for manufacturing a semiconductor device according to claim 1, wherein
in the resin sealing step, the lead frame that has been plated is used.

3. The method for manufacturing a semiconductor device according to claim 1, the method further comprising
a plating step for plating the lead frame after the laser light irradiation step.

4. The method for manufacturing a semiconductor device according to any one of claims 1 to 3, wherein
in a state where the lead frame is cut in the cutting step, the bottom face of the depressed portion in the lead frame and the part of the resin material in the depressed portion overlap each other in a height direction of the lead frame.

5. The method for manufacturing a semiconductor device according to any one of claims 1 to 4, wherein
in a state where the lead frame is cut in the cutting step, the part of the resin material in the depressed portion includes a resin end face formed through cutting, and
a height dimension of the resin end face is 50% or more and 80% or less of a height dimension of the depressed portion.

6. A semiconductor device comprising:
a lead frame in which a depressed portion is formed; and
a semiconductor chip bonded on the lead frame and resin-sealed with a resin material, the semiconductor device being produced by cutting a bottom face of the depressed portion in the lead frame, wherein
the bottom face of the depressed portion in the lead frame and the resin material in the depressed portion overlap each other in a height direction of the lead frame.

7. The semiconductor device according to claim 6, wherein
the resin material in the depressed portion includes a resin end face formed through cutting, and
a height dimension of the resin end face is 50% or more and 80% or less of a height dimension of the depressed portion.
